# EUROPEAN PATENT APPLICATION

(11) **EP 2 843 838 A1**
(43) Date of publication of application: **04.03.2015**
(21) Application number: 12874932.2
(22) Date of filing: 20.07.2012
(51) Int. Cl.: H03L 7/00

(54) **MULTIPLE CORE PROCESSOR DEVICE AND CLOCK CONTROL IMPLEMENTING METHOD THEREFOR**

(30) Priority: 24.04.2012 CN 201210122920
(71) Applicant: ZTE Microelectronics Technology Co., Ltd., Shenzhen, Guangdong 518055 (CN)
(72) Inventor: BI, Min, Shenzhen Guangdong 518057 (CN)
(74) Representative: Zerbi, Guido Maria
(86) International application number: PCT/CN2012/078961
(87) International publication number: WO 2013/159465

(57) **Abstract**

A multi-core processor device and a method for implementing clock control thereof are provided. The method includes: each first type of core processor running multiple sets of software systems employing a single phase-locked loop module, performing dynamic clock frequency selections respectively via corresponding clock controllers to control a clock; and a second type of core processor running only a single software system performing clock control via a sharable phase-locked loop module. The problem in the prior art of complexity and impreciseness in DFS implementation can be solved by the present application.

## Description

### Technical Field

The present invention relates to the field of mobile communication technology, and in particular, to a method for controlling a clock by using a multi-core architecture processor to support Dynamic Frequency Selection (DFS for short) technology and a multi-core processor device.

### Background of the Related Art

It can be seen from the current embedded consumer electronics that media processing is gradually integrated with wireless communications and 3D games, and its powerful functions bring increase in chip processing capacity, which results in power consumption being greatly increased in the complicated mobile application environment. For example, with respect to mobile phones, users often desire longer standby time, music listening time, and Moving Pictures Experts Group (MPEG) 4 viewing time. In such circumstances, how to reduce the power consumption of the embedded chips is extremely urgent. The DFS technology is considered in the industry as a relatively simple, feasible and effective measure to reduce the power consumption. Nokia N95 reduces the power consumption by 20% after using the DFS technology.

A basic principle of the DFS is that based on different loads of the core processor in different scenarios and different traffic volumes, clock frequencies of the processors are adjusted according to the load capacity, which can enable the effective power supply rate to be maximized to achieve the purpose of controlling dynamic power consumption in the premise of satisfying the transient performance. When the processor operates, the processing frequency thereof is ensured to enable it to satisfy the timing requirements; and when the processor does not operate or is transitioned from having an operating load to having no operating load, the operating frequency is reduced to enable the processor to reduce the dynamic power consumption. In particular, in a case that the software programs running in the core processor are more and more complex, the effect of controlling power consumption by DFS is better. This is because that when multiple subsystem software operates on the same core, each subsystem software maintains its own state machine, and when the state machines of all software return to zero, it illustrates that there is no operation on the core, and the clock of the core can be switched off to reduce the dynamic power consumption to zero. However, as there are many running software subsystems, it needs to take a certain time to monitor such process, which results in a high frequency clock being still on when the operating load is very small, thereby causing a waste of the dynamic power consumption.

How to implement the clock design of the DFS chip in the existing schemes will be set forth below by taking a dual-core system as an example.

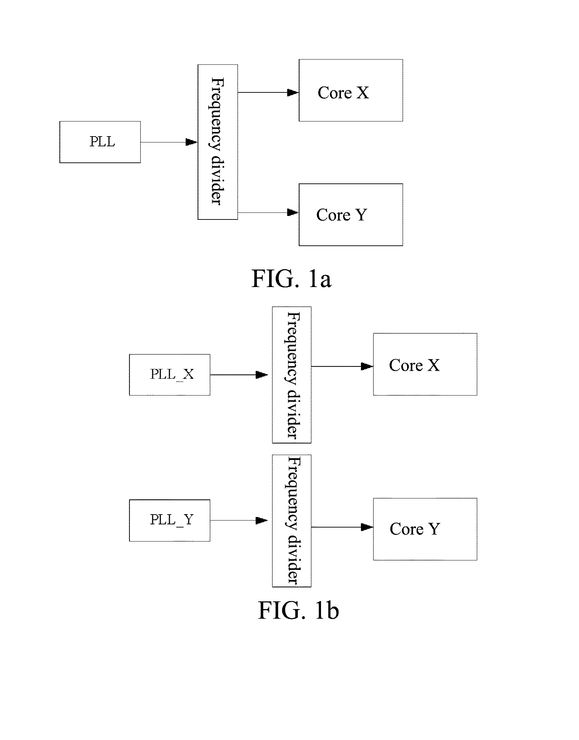

In Fig. 1a, core X/core Y share a Phase-Locked Loop (PLL). Frequency division is performed by a frequency divider on a clock signal which passed the PLL. The two cores may select outputs of different frequency dividers as clocks of cores, and when the adjustment capability of the frequency divider is not enough, the PLL must be adjusted to change the operating clock of the core. In the above design, as two cores use the same PLL, any instruction for adjusting the PLL may change the clocks of the two cores. Therefore, in such design, the clock frequency cannot be adjusted simply based on the load of a certain core, and must be adjusted by performing statistics on the loads of the two cores, interacting the load information of the two cores, evaluating the load capacities of the two cores respectively and then uniformly deciding the adjustment amount of the PLL. The more the cores are, the larger the amount of information needed to be interacted is, the more complex the decision condition is, and the easier the occurrence of a fault may be.

In Fig. 1b, each core, i.e., core X/core Y independently uses a PLL and a frequency divider. Each core may independently adjust the clock frequency based on its own load, without influencing other cores. However, in actual applications, the software carried on some cores only has one set of subsystem software, and the transition of the state machines is simple. For such core, the effect of controlling the power consumption of the DFS technology is basically of no effect. This is because for the core processor, the higher the clock frequency is, the faster the processing speed is; and the lower the clock frequency is, the slower the processing speed is, and the longer the duration is. When the software carried on the core is simple, the clocks of the cores may be immediately switched off by monitoring the state when the software does not operate, to achieve the purpose of reducing the dynamic power consumption. There is no condition that the high-frequency clock still needs to be on for a long time for transition of the state machines of a complex software system in a case of extremely low load. Thus, the control effect of the DFS is not prominent. Therefore, the above design method has defects of wasting the PLL and increasing a cost.

### Summary of the Invention

The present application provides a multi-core processor device and a method for implementing clock control thereof, to solve the problem in the prior art of complexity and impreciseness in DFS implementation.

In order to solve the above technical problem, the embodiments of the present invention provide a method for implementing clock control in a multi-core processor device, comprising:
each first type of core processor running multiple sets of software systems employing a single phase-locked loop module, and performing dynamic clock frequency selections respectively via corresponding clock controllers to control a clock; and
a second type of core processor running only a single software system performing clock control via a sharable phase-locked loop module.

In the above method, the step of performing dynamic clock frequency selections via corresponding clock controllers to control a clock comprises:
the clock controllers estimating load rates of corresponding core processors in real time, and deciding clock frequency information of the core processors according to the estimated load rates and a preset correspondence table between the load rates of the core processors and the clock frequency information; and
adjusting clock frequencies of the corresponding phase-locked loop modules according to the decided clock frequency information.

The step of deciding clock frequency information of the core processors according to the estimated load rates and the correspondence table comprises:
if judging that the estimated load rates exceed a maximum threshold, the clock controllers selecting preset maximum clock frequency information corresponding to the maximum threshold;
if judging that the estimated load rates are between the maximum threshold and a minimum threshold, selecting clock frequency information between preset maximum clock frequency information corresponding to the maximum threshold and minimum clock frequency information corresponding to the minimum threshold; and
if judging that the estimated load rates are lower than the minimum threshold, selecting preset minimum clock frequency information corresponding to the minimum threshold.

The method further comprises: a peripheral system and the second type of core processor sharing the sharable phase-locked loop module to control a clock.

The present application further provides a multi-core processor device, comprising: a first type of core processors running multiple sets of software systems, a second type of core processor running only a single software system, phase-locked loop modules and clock controllers, wherein,
each first type of core processor employs a single first phase-locked loop module, and performs dynamic clock frequency selection control respectively via corresponding clock controllers; and
the second type of core processor performs clock control via a sharable second phase-locked loop module.

The clock controller comprises:
a storage unit, configured to store a preset correspondence table between the load rates of the core processors and the clock frequency information;
a arbitration unit, configured to estimate a load rate of a core processor corresponding to the clock controller in real time, and decide clock frequency information of the core processor according to the estimated load rate and the preset correspondence table; and
an adjustment unit, configured to adjust clock frequency of the phase-locked loop module corresponding to the clock controller according to the decided clock frequency information.

The arbitration unit is configured to decide clock frequency information of the core processors corresponding to the clock controllers by the following mode: if judging that the estimated load rates exceed a maximum threshold, selecting maximum clock frequency information corresponding to the maximum threshold from the correspondence table; if judging that the estimated load rates are between the maximum threshold and a minimum threshold, selecting clock frequency information between maximum clock frequency information corresponding to the maximum threshold and minimum clock frequency information corresponding to the minimum threshold from the correspondence table; and if judging that the estimated load rates are lower than the minimum threshold, selecting minimum clock frequency information corresponding to the minimum threshold from the correspondence table.

The device further comprises a peripheral system, wherein, the peripheral system and the second type of core processor share the second phase-locked loop module to perform clock control.

In conclusion, the present application provides a multi-core processor device and a method for implementing clock control thereof, to solve the problem in the prior art of complexity and impreciseness in DFS implementation.

### Brief Description of Drawings

Figs. 1a and 1b are diagrams of multi-core clock control in the related technologies;
Fig. 2 is a diagram of a multi-core processor device according to an embodiment of the present invention; and
Fig. 3 is a flow chart of performing DFS to control a clock according to an embodiment of the present invention.

### Preferred Embodiments of the Present Invention

DFS is a technology widely used for reducing power consumption of a core. For a multi-core system, the design method thereof is much more complex than a single core. This is because in a processor of the multi-core system, the tasks and roles for various cores are different, the load capacities thereof are different, and the requirements on the adjustment amounts of the DFS are also different. It needs to analyze the requirements to design the clock scheme; and in addition, the DFS adjustment of the core also cannot influence clock frequencies of peripherals, since some peripherals can normally operate only at a fixed frequency.

In order to make the purpose, technical schemes and advantages of the present application more clear and obvious, the embodiments of the present invention will be described in detail in conjunction with accompanying drawings hereinafter. It should be illustrated that without conflict, the embodiments in the application and the features of the embodiments can be randomly combined with each other.

A method for implementing clock control in a multi-core processor device according to an embodiment of the present invention comprises the following steps.

In S10, each first type of core processor running multiple sets of software systems employs a single phase-locked loop module, and performs dynamic clock frequency selection control respectively via corresponding clock controllers; and

In S20, a second type of core processor running only a single software system performs clock control via a sharable phase-locked loop module.

The present embodiment performs division according to the actual operating contents of the multi-core processor, to divide the multiple cores in the multi-core processor into two types. The first type of core processor operates multiple sets of software systems, the state machine is complex, the control effect of the DFS is prominent, and each core uses a single PLL; and the second type of core processor only processes a single software system, the state machine is simple, and may share one PLL to operate with other systems.

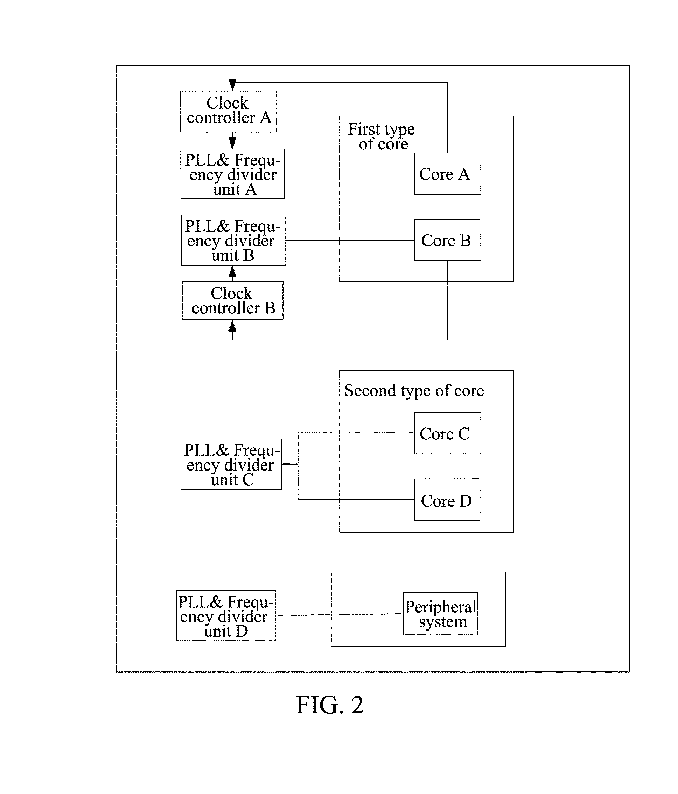

Fig. 2 is a diagram of a multi-core processor device according to an embodiment of the present invention. As shown in Fig. 2,
for the first type of core processor (core A and core B in Fig. 2), the PLL of each core corresponds to a clock controller. The clock controller stores a preset table (i.e., a correspondence table between the load rates of the core processors and the clock frequency information). The table specifies maximum/minimum clock frequency information required for supporting the load corresponding to the core load percentage information, and the information may be written in advance using software;

In addition, the clock controller further includes a arbitration unit, which estimates the workload of the software according to the core load percentage, and selects a frequency required to be supported in the (minimum, maximum) supporting frequencies. The decision criterion may be written in advance using software;

In general, when the load rate of the core processor (CPU for short) achieves above 50% for example, the maximum supporting clock is selected, since at this time the core is processing a large amount of data and the processing amount may increase. In order to further predict and adapt a high-speed processing amount, the maximum supporting clock is selected; and when the load rate is lower than 10% for example, the minimum supporting frequency is used, and at this time, the task of the core basically tends to a procedure in which the process has been completed, and only some state machines are transitioned; and when the load rate is higher than 10% and lower than 50%, an intermediate frequency between the minimum frequency and the maximum frequency is used so that the frequency changes with the load.

Such design also complies with the design idea that the longer the execution time is, the larger the leakage current is and the larger the power consumption is in the deep-submicron technology. When the core is in an operating state, the clock frequency is enhanced as much as possible, to enable the work to be done as soon as possible. When the core is in a state transition procedure, a low frequency clock is used to avoid that a state transition procedure of a complex software system is too long thereby resulting in a waste of the power consumption.

The clock controller automatically adjusts the PLL module (i.e., the PLL and the frequency divider unit A or the PLL and the frequency divider unit B in Fig. 2) according to the decision output of the arbitration unit, so that the clock output meets the requirements on the core load. Such process is completed automatically by hardware, is highly efficient and needs not participation by software, thereby ensuring fast transition between clock frequencies of the CPU to support the requirements of the services.

For a multi-core processor supporting the DFS, except that the core processor needs to consider the DFS technology, the remaining peripheral systems normally operate using a fixed frequency. When the fixed frequency changes, these peripheral systems will unpredictably break down. Therefore, an independent PLL and a frequency divider can be used to support the requirements on the clock of these peripherals.

The second type of core processor (core C and core D in Fig. 2) is a core processor on which a simple software system runs, which may share one sharable PLL module (the PLL and the frequency divider unit C in Fig. 2) to provide the clock; and the PLL module of the peripheral system which may be reused (the PLL and the frequency divider unit D in Fig. 2) provides a fixed clock. Of course, the peripheral system may also share the PLL module with the second type of core processor.

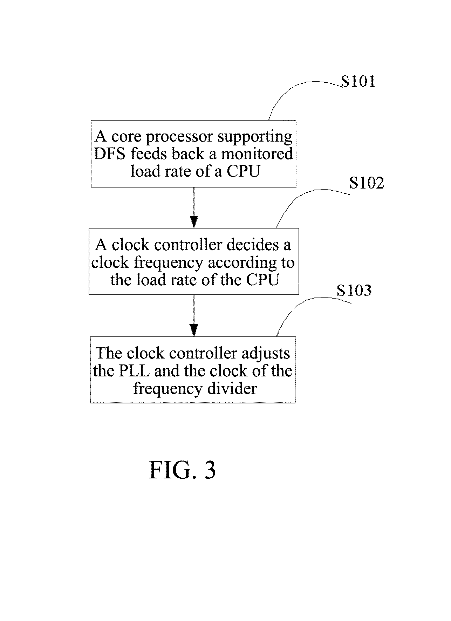

Fig. 3 is a flowchart of performing DFS to control a clock according to an embodiment of the present invention. As shown in Fig. 3, the method according to the present embodiment includes the following steps.
in step S101, a core processor supporting DFS adjustment feeds back a load rate of a CPU to a clock controller according to a monitored condition of the load of the CPU;
in step S102, the clock controller performs comparison according to the feedback information, judges that the load rate of the CPU meets a level supported by a certain clock frequency, and starts to decide a clock frequency of the CPU according to a predefined decision criterion; and
in step S103, the clock controller automatically adjusts the PLL and the frequency divider according to the decided clock frequency, to enable the clock of the core processor to meet the requirements on the clock frequency.

A person having ordinary skill in the art can understand that all or a part of steps in the above method can be implemented by programs instructing related hardware, and the programs can be stored in a computer readable storage medium, such as a read-only memory, disk or disc etc. Alternatively, all or a part of steps in the above embodiments can also be implemented by one or more integrated circuits. Accordingly, each module/unit in the above embodiments can be implemented in a form of hardware, or can also be implemented in a form of software functional module. The present application is not limited to any particular form of a combination of hardware and software.

The above description is only the preferred embodiments of the present application. Of course, the present application can have a plurality of other embodiments. Without departing from the spirit and substance of the present application, those skilled in the art can make various corresponding changes and variations according to the present invention, and all these corresponding changes and variations should belong to the protection scope of the appended claims in the present application.

### Industrial Applicability

The embodiments of the present invention provide a multi-core processor device and a method for implementing clock control thereof, to solve the problem in the related art of complexity and impreciseness in DFS implementation.

## Claims

1. A method for implementing clock control in a multi-core processor device, comprising:
each core processor of a first type running multiple sets of software systems employing a single phase-locked loop module, and performing dynamic clock frequency selection respectively via a corresponding clock controller to control a clock; and
a core processor of a second type running only a single software system performing clock control via a sharable phase-locked loop module.

2. The method according to claim 1, wherein, the step of performing dynamic clock frequency selection via a corresponding clock controller to control a clock comprises:
the clock controller estimating a load rate of a corresponding core processor in real time, and deciding clock frequency information of the core processor according to the estimated load rate and a preset correspondence table between load rates of core processors and clock frequency information; and
adjusting a clock frequency of the corresponding phase-locked loop module by using the decided clock frequency information.

3. The method according to claim 2, wherein, the step of deciding clock frequency information of the core processor according to the estimated load rate and the correspondence table comprises:
if judging that the estimated load rate exceeds a maximum threshold, the clock controller selecting preset maximum clock frequency information corresponding to the maximum threshold;
if judging that the estimated load rate is between the maximum threshold and a minimum threshold, selecting clock frequency information between preset maximum clock frequency information corresponding to the maximum threshold and minimum clock frequency information corresponding to the minimum threshold; and
if judging that the estimated load rate is lower than the minimum threshold, selecting preset minimum clock frequency information corresponding to the minimum threshold.

4. The method according to any of claims 1-3, further comprising:
a peripheral system and the core processor of the second type sharing the sharable phase-locked loop module to control a clock.

5. A multi-core processor device, comprising: core processors of a first type running multiple sets of software systems, a core processor of a second type running only a single software system, phase-locked loop modules and clock controllers, wherein,
each of the core processors of the first type employs a single first phase-locked loop module, and performs dynamic clock frequency selection control respectively via a corresponding clock controller; and
the core processor of the second type performs clock control via a sharable second phase-locked loop module.

6. The device according to claim 5, wherein, the clock controller comprises:
a storage unit, configured to store a preset correspondence table between load rates of core processors and clock frequency information;
a arbitration unit, configured to estimate a load rate of a core processor corresponding to the clock controller in real time, and decide clock frequency information of the core processor according to the estimated load rate and the correspondence table; and
an adjustment unit, configured to adjust clock frequency of the phase-locked loop module corresponding to the clock controller by using the decided clock frequency information.

7. The device according to claim 6, wherein,
the arbitration unit is configured to decide clock frequency information of the core processor corresponding to the clock controller by the following way: if judging that the estimated load rate exceeds a maximum threshold, selecting maximum clock frequency information corresponding to the maximum threshold from the correspondence table; if judging that the estimated load rate is between the maximum threshold and a minimum threshold, selecting clock frequency information between maximum clock frequency information corresponding to the maximum threshold and minimum clock frequency information corresponding to the minimum threshold from the correspondence table; and if judging that the estimated load rate is lower than the minimum threshold, selecting minimum clock frequency information corresponding to the minimum threshold from the correspondence table.

8. The device according to any of claims 5-7, further comprising a peripheral system, the peripheral system and the core processor of the second type share the second phase-locked loop module to perform clock control.
